# EUROPÄISCHE PATENTSCHRIFT

(11) **EP 2 194 488 B1**
(45) Veröffentlichungstag und Bekanntmachung des Hinweises auf die Patenterteilung: **01.08.2012**
(21) Anmeldenummer: 09014897.4
(22) Anmeldetag: 01.12.2009
(51) Int. Cl.: G06K 19/073, G06F 21/00, H01L 25/00, H01L 23/00, H04L 29/00

(54) **Datenträger mit elektrischer Zerstörungseinrichtung**
Data carrier with electric destruction device
Support de données doté d'un dispositif de destruction électrique

(30) Priorität: 03.12.2008 DE 102008060295
(43) Veröffentlichungstag der Anmeldung: 09.06.2010
(73) Patentinhaber: Giesecke & Devrient GmbH, 81677 München (DE)
(72) Erfinder: Rankl, Wolfgang, 81825 München (DE)

(56) Entgegenhaltungen:
- DE-A1- 4 221 110
- DE-A1- 10 060 912
- JP-A- 2006 202 090
- US-A1- 2005 012 616

## Beschreibung

Die Erfindung betrifft einen tragbaren Datenträger mit einer elektrischen Schaltkreisanordnung, sowie mit einer benachbart zur Schaltkreisanordnung angeordneten elektrischen Zerstörungseinrichtung, die zum Erzeugen von Wärme in Reaktion auf einen die Zerstörungseinrichtung durchfließenden Stromfluss eingerichtet ist und dazu eingerichtet ist, die Schaltkreisanordnung zumindest teilweise funktionsunfähig zu machen.

Der Datenträger kann insbesondere als Chipkarte gestaltet sein oder als Chipmodul, das zum Einbau in eine solche Chipkarte vorgesehen ist. Der Körper ist z.B. ein aus Kunststoff gefertigter Chipkartenkörper.

Die Schaltkreisanordnung ist wahlweise auf einem Chip oder mehreren Chips, die wahlweise miteinander gekoppelt sein können, implementiert.

Die Schaltkreisanordnung ist wahlweise als Mikroprozessor gestaltet, mit einer CPU und ein oder mehreren Speichern, oder als Mikrocontroller. Der Datenträger ist beispielsweise als Mikroprozessor-Chipkarte oder Smart Card gestaltet.

Wahlweise ist die Schaltkreisanordnung als Speicheranordnung gestaltet, mit einem ein oder mehrere Speicherbereiche aufweisenden Speicherbereichsystem und einem Speicherverwaltungssystem, z.B. Speichercontroller oder Mikrocontroller, zum Verwalten des Speicherbereichsystems. Der Datenträger kann beispielsweise eine Speicherkarte sein.

In der industriellen Chipkarten-Fertigung werden Chipkarten in der Regel initialisiert und personalisiert, um sie mit den für ihre Bestimmung erforderlichen Daten zu programmieren. Teilweise werden dabei geheime Daten in den Chip der Chipkarte programmiert, z.B. Authentisierungsdaten für Zahlungsverkehrkarten oder (U)SIM-Karten für die Mobilfunkkommunikation. Im Bedarfsfall ist es in der Chipkarten-Fertigung derzeit üblich, dass nicht funktionsfähige, fehlerhaft initialisierte oder fehlerhaft personalisierte Chipkarten geshreddert werden. Das Resultat des Shredderns sind kleine Kunststoffstückchen, die etwa 2 Millimeter breit und 10 Millimeter lang sind. Normalerweise werden die Kunststoffstückchen aus dem Shreddervorgang durch ein Entsorgungsunternehmen beseitigt.

Mit dem Vorgang des Shredderns soll insbesondere sichergestellt werden, dass auch der Chip der Chipkarte zerstört wird. Denn aus einem Chipkarten-Chip, der sich in einem undefinierten Fertigungszustand befindet, könnte ein potentieller Angreifer möglicherweise mit einem gewissen Aufwand geheime Daten auslesen, die bei der vorangegangenen Initialisierung oder Personalisierung in den Chip programmiert worden sind.

Weiter kann es für tragbare Datenträger wie z.B. Mikroprozessor-Chipkarten (Smart Cards) gewünscht sein, dass sie nach Gebrauch, beispielsweise nach Ablauf einer vorbestimmten Gültigkeitsdauer, unbrauchbar gemacht werden. Beispielsweise haben Chipkarten, die als Zahlungsverkehrkarten oder Chipkarten für das Gesundheitswesen (z.B. Krankenversichertenkarten) gestaltet sind, eine begrenzte Gültigkeitsdauer, nach deren Ablauf die Chipkarten vom Herausgeber zurückgefordert und zerstört werden.

Die immer weiter voranschreitende Miniaturisierung in der Halbleiterfertigung und die daraus resultierende immer höhere Integrationsdichte der Halbleiterbauelemente führt dazu, dass heutige Chipkarten-Mikrocontroller-Chips aus dem unteren Preissegment mitunter Kantenlängen von nur mehr ungefähr 2 Millimeter mal 1 Millimeter haben. Die Konsequenz dieser geringen Chipabmessungen ist, dass ein Shreddern einer Chipkarte nicht mehr zuverlässig zu einer Zerstörung ihres Chips führt.

Prinzipiell ist es denkbar, mit einem verbesserten Shredder kleinteiligeres Shreddergut zu erzeugen oder die Chipkarten mit einer Mühle zu Mehl zu mahlen. Eine vollständige Sicherheit, dass der Chip zerstört wird, liefern auch solche Maßnahmen nicht, zudem bedeuten sie einen erheblichen zusätzlichen Zeitaufwand.

Bekannt ist es auch, mittels geeigneter logischer Kommandos den Mikroprozessor oder Mikrocontroller einer Chipkarte zu deaktivieren. Diese Methode ist nur anwendbar, falls der Mikroprozessor oder Microcontroller und das zugehörige Betriebssystem funktionsfähig sind.

In der Patentanmeldung DE 195 18 901 A1 ist ein Locher zum Lochen des Chips einer Chipkarte offenbart.

Die Gebrauchsmusterschrift DE 20 2005 002 351 U1 offenbart einen tragbaren Datenträger, z.B. Diskette, CD, Festplatte oder Chip, der in einem Gehäuse angeordnet ist, sowie eine Vorrichtung zur Beseitigung der auf dem tragbaren Datenträger gespeicherten Information, bei der auf Knopfdruck mittels eines piezoelektrischen Elements durch Funkenentladung die Information irreversibel gelöscht werden kann, ohne den Datenträger aus seinem Gehäuse zu entnehmen.

DE 42 21110 A1 offenbart einen manipulationsgesicherten Chipkartenleser, dessen Einführschlitz mittels eines Schiebers verschließbar ist, sobald eine Chipkarte bis in Lesestellung in den Einführschlitz eingeführt ist. Bei der abzuwehrenden Manipulation wird eine Chipkarte, an deren Kontaktflächen ein Kabel angeschlossen ist, in den Einführschlitz eingebracht, so dass das Kabel aus dem Kartenleser herausragt. Zur Abwehr der Manipulation ist an einer Schmalseite des Schiebers ein Heizdraht vorgesehen, mit dem das Kabel zerstört werden soll.

JP 06325223 beschreibt eine Kontaktlos-Chipkarte mit einer Empfangsschaltung, einem Datenbereich, einem Spannungsgenerator und einer zwischen den Spannungsgenerator und die Empfangsschaltung sowie den Datenbereich elektrisch gekoppelten Zerstörungsschaltung. Auf Veranlassung der Zerstörungsschaltung lässt sich der Spannungsgenerator an zumindest Teile der Empfangsschaltung und des Datenbereichs ankoppeln, um diese Schaltungsteile zu zerstören oder unbrauchbar zu machen.

JP 2006202090, Grundlage für den Oberbegriff von Anspruch 1, beschreibt ein Funkettikett mit einer CPU, einem durch die CPU ansteuerbaren Speichermodul und einer Zerstörungsschaltung, mit der Speicherinhalte von einzelnen Speicherzellen des Speichermoduls nach Ablauf einer vorbestimmten Lesbarkeitsdauer unlesbar gemacht werden können. Bei der Zerstörungsschaltung ist für jede zerstörbare Speicherzelle eine Sicherung mit der Speicherzelle in Serie geschaltet. Zum unlesbar Machen des Inhalts der Speicherzelle wird durch die CPU die zugehörige Sicherung durchgebrannt.

Beim nächstliegenden Stand der Technik aus JP 2006202090 ist eine Zerstörungseinrichtung mit einer Schaltkreisanordnung gekoppelt, indem die Sicherungen mit den Speicherzellen in Serie geschaltet sind. Daher ist nicht auszuschließen, dass die Sicherungen einen Einfluss auf die Funktionalität der Speicherzellen haben und beim Design der Speicherzellen mit berücksichtigt werden müssen. Zudem muss die Schaltkreisanordnung ansteuerbar, also zumindest bedingt funktionsfähig, sein, damit die Sicherungen durchgebrannt werden können.

Der Erfindung liegt die Aufgabe zu Grunde, einen Datenträger mit einer elektrischen Schaltkreisanordnung, sowie mit einer kostengünstigen, zuverlässigen und vielseitig einsetzbaren elektrischen Zerstörungseinrichtung, um die Schaltkreisanordnung zumindest teilweise funktionsunfähig zu machen, zu schaffen.

Die Aufgabe wird gelöst durch einen Datenträger nach Anspruch 1. Vorteilhafte Ausgestaltungen der Erfindung sind in den abhängigen Ansprüchen angegeben.

Der erfindungsgemäße Datenträger gemäß dem unabhängigen Anspruch 1 hat eine elektrische Schaltkreisanordnung, sowie eine benachbart zur Schaltkreisanordnung angeordnete elektrische Zerstörungseinrichtung, die zum Erzeugen von Wärme zur thermischen Zerstörung der Schaltkreisanordnung in Reaktion auf einen die Zerstörungseinrichtung durchfließenden Stromfluss eingerichtet ist und dazu eingerichtet ist, die Schaltkreisanordnung zumindest teilweise funktionsunfähig zu machen. Der Datenträger zeichnet sich dadurch aus, dass die Zerstörungseinrichtung unter Verwendung einer stromgleichrichtenden Einrichtung, z.B. einer Diode, von der Schaltkreisanordnung entkoppelt ist.

Die erzeugte Wärme strahlt in die Umgebung der Zerstörungseinrichtung und somit zur benachbarten Schaltkreisanordnung ab. Die Beabstandung zwischen der Zerstörungseinrichtung bzw. ihren Teilen und der Schaltkreisanordnung bzw. ihren Teilen ist derart geeignet gewählt, dass die erzeugte Wärme ausreicht, um die Schaltkreisanordnung thermisch zu beschädigen oder zu zerstören und dadurch funktionsunfähig zu machen.

Im Gegensatz zu einem Shredder, in dem der Datenträger mechanisch zerstört wird, ist die erfindungsgemäße Zerstörungseinrichtung eine elektrisch zerstörend wirkende Zerstörungseinrichtung und gewährleistet zuverlässig die Zerstörung der Schaltkreisanordnung. Im Gegensatz zum nächstliegenden Stand der Technik aus JP 2006202090 ist die Zerstörungseinrichtung von der Schaltkreisanordnung, vorzugsweise galvanisch und logisch, entkoppelt, so dass eine Beeinflussung der Funktionalität der Schaltkreisanordnung durch die Zerstörungseinrichtung entfällt. Zudem ist eine Funktionsfähigkeit der Schaltkreisanordnung entbehrlich. Die Zerstörungseinrichtung kann auch ohne funktionsfähige Schaltkreisanordnung betätigt werden. Sensible Schaltungsteile wie z.B. CPU-Register oder Glue-Logik-Teile können thermisch zerstört werden, ohne dass die Schaltkreisanordnung, z.B. ein Mikroprozessor oder Mikrocontroller, funktionsfähig zu sein braucht. Die Zerstörungseinrichtung ist daher äußerst vielseitig und unabhängig von Designanforderungen an die Schaltkreisanordnung und von der Funktionsfähigkeit der Schaltkreisanordnung einsetzbar. Zudem lässt sich eine Zerstörungseinrichtung, die darauf basiert, in Reaktion auf einen sie durchfließenden Stromfluss Wärme zu erzeugen, z.B. nach Art einer Schmelzsicherung oder eines Heizdrahts, mit vergleichsweise geringem technischem und finanziellem Aufwand implementieren. Die Beschaltung der Zerstörungseinrichtung kann in der Regel im Wesentlichen mit ohnehin für die Beschaltung der Schaltkreisanordnung vorhandenen Mitteln erfolgen.

Daher ist gemäß Anspruch 1 ein Datenträger mit einer elektrischen Schaltkreisanordnung sowie mit einer kostengünstigen, zuverlässigen und vielseitig einsetzbaren elektrischen Zerstörungseinrichtung, um die Schaltkreisanordnung zumindest teilweise funktionsunfähig zu machen, geschaffen.

Wahlweise weist die Zerstörungseinrichtung mindestens eine Zerstörungsleiterbahn mit zumindest einem durch Stromfluss mit ausreichender Stromstärke in der Zerstörungsleiterbahn erhitzbaren Sicherungsabschnitt auf. Wahlweise ist der Zerstörungsabschnitt durch den Stromfluss zerstörbar, insbesondere durch Schmelzen, und gibt bei seiner Zerstörung, insbesondere durch Schmelzen, Wärme ab. Der Sicherungsabschnitt funktioniert somit z.B. nach dem Prinzip einer Schmelzsicherung, deren verdünnter Bereich bei ausreichend hohem Stromfluss durchschmilzt und dabei Hitze in seine Umgebung abstrahlt, die wiederum die Umgebung thermisch schädigt. Der Sicherungsabschnitt ist wahlweise als verdünnter Bereich der Zerstörungsleiterbahn ausgebildet, der einen geringeren Querschnitt hat als die Zerstörungsleiterbahn abseits des Sicherungsabschnitts, oder anderweitig derart gestaltet, dass im Sicherungsabschnitt die Stromdichte höher ist als in der sonstigen Zerstörungsleiterbahn.

Wahlweise weist die Zerstörungseinrichtung mehrere Zerstörungsleiterbahnen mit jeweils zumindest einem durch Stromfluss mit ausreichender Stromstärke in der Zerstörungsleiterbahn erhitzbaren Sicherungsabschnitt auf. Die einzelnen Zerstörungsleiterbahnen sind wahlweise parallel geschaltet.

Wahlweise ist der Sicherungsabschnitt eng benachbart zu einem vorbestimmten Schaltkreisteil der Schaltkreisanordnung angeordnet, der für die Funktionsfähigkeit der Schaltkreisanordnung wesentlich ist oder/und für den eine Zerstörung durch die Zerstörungseinrichtung gewünscht ist. Ggf. ist, bei einer Zerstörungseinrichtung mit mehreren Zerstörungsleiterbahnen, wahlweise bei jeder Zerstörungsleiterbahn der Sicherungsabschnitt benachbart zu einem vorbestimmten wesentlichen oder /und zu zerstörenden Schaltkreisteil angeordnet.

Als vorbestimmter Schaltkreisteil ist wahlweise mindestens eine der folgenden Funktionseinheiten vorgesehen: ein oder mehrere Register einer CPU (CPU = Central Processing Unit), ein Verstärker eines Bussystems, ein oder mehrere Teile einer Glue-Logik (GLUE = general logic unit expansion). Die Glue-Logik oder Teile davon sind z.B. daran beteiligt, Statusinformationen über den Status von Teilen, z.B. Funktionsblöcken, einer Schaltkreisanordnung, z.B. eines Mikroprozessors oder Mikrocontrollers, an eine Schnittstelle der Schaltkreisanordnung bereitzustellen, von wo aus die Statusinformationen z.B. von außerhalb der Schaltkreisanordnung ausgelesen werden können. Daher sollte ein unberechtigtes Auslesen der Glue-Logik zuverlässig verhindert werden. Insbesondere bei der Glue-Logik kann es ggf. ausreichend sein, wenn ein einzelnes sensibles Teilelement oder einige wenige solche sensible Teilelemente funktionsunfähig gemacht wird bzw. werden, unter Umständen ein einzelner Transistor oder einige wenige Transistoren, damit aus der gesamten Glue-Logik keine sensible Information mehr gewonnen werden kann. Wahlweise ist benachbart zu jedem solchen sensiblen Teilelement ein Sicherungsabschnitt einer Zerstörungsleiterbahn angeordnet, mit dem das jeweilige Teilelement thermisch zerstörbar ist.

Wahlweise ist die Zerstörungseinrichtung so gestaltet, dass beim Normalbetrieb des Datenträgers in einem Lesegerät für Datenträger keine versehentliche Zerstörung der Schaltkreisanordnung durch die Zerstörungseinrichtung erfolgt. Ggf. wird wahlweise beim Normalbetrieb der Sicherungsabschnitt nicht ausreichend erhitzt bzw. nicht zerstört bzw. er schmilzt nicht durch. Wahlweise ist ein Grenz-Stromfluss in der Zerstörungseinrichtung, ab dessen Erreichen oder Überschreiten die erzeugte Wärme ausreicht, um die Schaltkreisanordnung funktionsunfähig zu machen, höher, als ein beim Normalbetrieb des Datenträgers höchstens erzielbarer Maximal-Stromfluss. Teilweise liefert z.B. ein Terminal für Chipkarten einen Stromfluss mit einer Stromstärke von maximal zwischen 20 mA und 100 mA. Verbraucht ein Chipkarten-Chip mehr Strom, wird der Strom auf diesen Maximalwert begrenzt, oder der Strom wird ganz abgeschaltet.

Vorzugsweise ist die Zerstörungseinrichtung so gestaltet, z.B. der Grenz-Stromfluss so eingestellt, dass anlässlich eines versehentlichen Beaufschlagens der Zerstörungseinrichtung mit einer Versorgungsspannung, die eigentlich für den Normalbetrieb der Schaltkreisanordnung vorgesehen ist, die erzeugte Wärme nicht zur Zerstörung der Schaltkreisanordnung ausreicht. Beispielsweise schmilzt unter diesen Bedingungen der Sicherungsabschnitt noch nicht oder/ und er wird nicht ausreichend heiß.

Wahlweise weist die Schaltkreisanordnung zwei Schaltungs-Versorgungs-Anschlüsse auf, über welche die Schaltkreisanordnung mit einer Versorgungsspannung beaufschlagbar ist. Die Zerstörungseinrichtung weist wahlweise zwei von den Schaltungs-Versorgungs-Anschlüssen unter Verwendung der stromgleichrichtenden Einrichtung entkoppelte Zerstörungs-Versorgungs-Anschlüsse auf.

Der Datenträger weist wahlweise weiter ein Kontaktfeld mit einer Mehrzahl von Kontakten zur galvanischen Kontaktierung der Schaltkreisanordnung auf, wobei zwei Versorgungs-Kontakte der Kontakte mit den Schaltungs-Versorgungs-Anschlüssen der Schaltkreisanordnung und mit den Zerstörungs-Versorgungs-Anschlüssen der Zerstörungseinrichtung elektrisch koppelbar oder gekoppelt sind. Dabei ist sichergestellt, dass die Schaltungs-Versorgungs-Anschlüsse und die Zerstörungs-Versorgungs-Anschlüsse voneinander entkoppelt sind, so dass die Schaltkreisanordnung und die Zerstörungseinrichtung voneinander entkoppelt sind.

Die Entkopplung unter Verwendung einer stromgleichrichtenden Einrichtung, z.B. einer Diode, kann bei einem Datenträger mit dem oben beschriebenen Kontaktfeld beispielsweise dadurch verwirklicht sein, dass die Versorgungs-Kontakte mit den SchaltungsVersorgungs-Anschlüssen der Schaltkreisanordnung direkt elektrisch gekoppelt sind und mit den Zerstörungs-Versorgungs-Anschlüssen der Zerstörungseinrichtung über eine stromgleichrichtende Einrichtung, z.B. Diode, elektrisch gekoppelt sind. Anlässlich eines Anlegens einer Versorgungsspannung an die Versorgungs-Kontakte mit einer ersten Polung wird an die Schaltungs-Versorgungs-Anschlüsse der Schaltkreisanordnung eine Betriebsspannung angelegt, die einen bestimmungsgemäßen Betrieb der Schaltkreisanordnung ermöglicht, wohingegen die Zerstörungs-Versorgungs-Anschlüsse der Zerstörungseinrichtung mittels der stromgleichrichtenden Einrichtung, z.B. Diode, von den Versorgungs-Kontakten und damit von der Versorgungsspannung elektrisch entkoppelt sind, so dass kein Strom in der Zerstörungseinrichtung fließt. Anlässlich eines Anlegens einer Versorgungsspannung an die Versorgungs-Kontakte mit einer zweiten Polung, die zur ersten Polung entgegengesetzt ist, wird durch die an die Zerstörungs-Versorgungs-Anschlüsse angelegte Versorgungsspannung ein Stromfluss in der Zerstörungseinrichtung erzeugt. Eine Versorgungsspannung in Höhe der normalen Versorgungsspannung zum Betrieb der Schaltkreisanordnung reicht vorzugsweise noch nicht aus, um in der Zerstörungseinrichtung einen ausreichenden Stromfluss zu erzeugen, um die Schaltkreisanordnung zu zerstören. Hierdurch soll sichergestellt werden, dass bei einem versehentlichen Vertauschen der Versorgungs-Kontakte, d.h. bei einer versehentlichen Beschaltung mit vertauschter Polarität, die Zerstörungseinrichtung nicht wirksam wird. Erst bei Anlegen einer ausreichend hohen Versorgungsspannung mit vertauschter Polarität wird die Schaltkreisanordnung durch die von der Zerstörungseinrichtung abgestrahlte Wärme thermisch zerstört.

Wahlweise ist die Zerstörungseinrichtung zur Schaltkreisanordnung parallel geschaltet.

Wahlweise ist die Zerstörungseinrichtung derart benachbart zur Schaltkreisanordnung angeordnet, dass die Zerstörungseinrichtung in ein Schaltungslayout der Schaltkreisanordnung integriert ist und bei Bedarf räumlich mit ihr verzahnt ist, so dass z.B. ggf. jeder Sicherungsabschnitt räumlich benachbart zu einem gewünschten Element der Schaltkreisanordnung angeordnet ist.

Bei einem erfindungsgemäßen Verfahren zum funktionsunfähig Machen eines erfindungsgemäßen Datenträgers wird eine elektrische Zerstörungsspannung an die Zerstörungs-Versorgungs-Anschlüsse angelegt. Die Zerstörungsspannung ist ausreichend hoch, damit ausreichend Wärme erzeugt wird, um die Schaltkreisanordnung thermisch zu zerstören. Beispielsweise schmilzt bei der Zerstörungsspannung der Sicherungsabschnitt der bzw. einer jeden Zerstörungsleiterbahn durch.

Wahlweise wird, während die elektrische Zerstörungsspannung an die Zerstörungs-Versorgungs-Anschlüsse angelegt ist, ein elektrischer Widerstand der Zerstörungseinrichtung im Verlauf der Zeit gemessen. Dabei wird das funktionsunfähig Machen als vollendet bewertet, sobald der elektrische Widerstand einen vorbestimmten Grenz-Widerstand erreicht oder überschritten hat. Wahlweise wird zudem - entweder sofort oder nach Ablauf eines vorbestimmten Sicherungszeitintervalls - das Anlegen der Zerstörungsspannung beendet, sobald der elektrische Widerstand den vorbestimmten Grenz-Widerstand erreicht oder überschritten hat. Bei einer Zerstörungseinrichtung mit mindestens einer Zerstörungsleiterbahn mit je zumindest einem Sicherungsabschnitt ist beispielsweise die Zerstörungsleiterbahn hochohmig, sobald der Sicherungsabschnitt durchgeschmolzen ist. Sobald der hochohmige Zustand erreicht ist, ist der Sicherungsabschnitt unter Abgabe von Wärme geschmolzen und die Zerstörung der Schaltkreisanordnung erfolgreich beendet.

Das erfindungsgemäße Verfahren wird wahlweise in einem Terminal für Datenträger in einem gesicherten Bereich einer Anlage zur Produktion von Datenträgern durchgeführt. Hierbei werden wahlweise nicht funktionsfähige, fehlerhaft initialisierte oder fehlerhaft personalisierte Chipkarten, die aus dem Produktionsprozess entfernt werden sollen, elektrisch zerstört. Nach der elektrischen Zerstörung können die Chipkarten wahlweise zusätzlich geshreddert oder anderweitig mechanisch zerstört werden.

Wahlweise wird das Verfahren in einem Terminal für Datenträger in einem öffentlich zugänglichen Bereich durchgeführt, insbesondere in einem Zahlungsverkehrterminal oder einem Geldausgabeautomaten.

Im Folgenden wird die Erfindung an Hand von Ausführungsbeispielen und unter Bezugnahme auf die Zeichnung näher erläutert, in der zeigen:
- Fig. 1: schematisch eine Schaltkreisanordnung mit einer benachbart dazu angeordneten Zerstörungseinrichtung, gemäß einer Ausführungsform der Erfindung;

- Fig. 2: die Beschaltung der Zerstörungseinrichtung aus Fig.1 im Zerstörungsbetrieb (oben) und im normalen Betrieb (unten);
- Fig. 3: schematisch eine Schaltkreisanordnung mit einer benachbart dazu angeordneten Zerstörungseinrichtung, gemäß einer weiteren Ausführungsform der Erfindung.

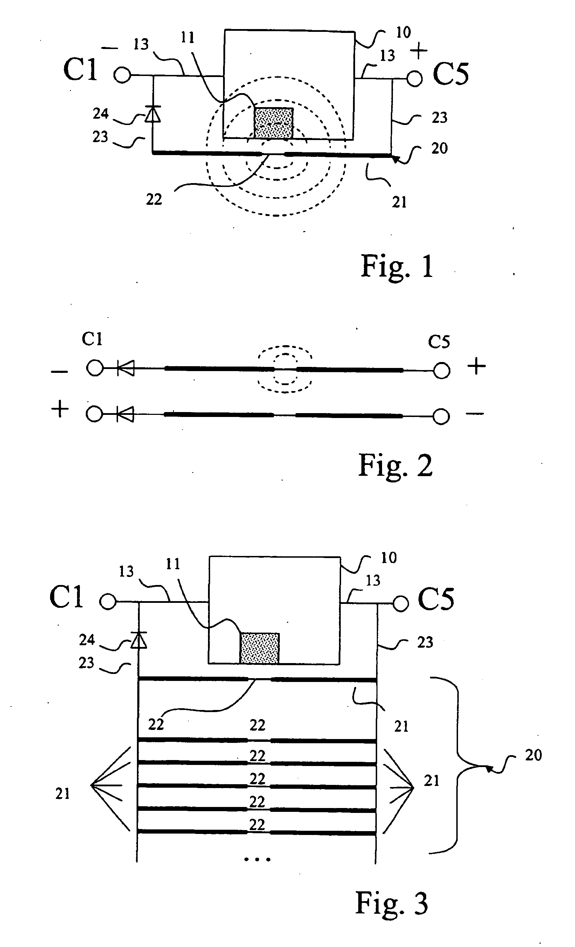

Fig. 1 zeigt schematisch ein Schaltbild einer Schaltkreisanordnung 10 mit einer benachbart dazu angeordneten Zerstörungseinrichtung 20, gemäß einer Ausführungsform der Erfindung, beschaltet mit einer Polung zum Zerstörungsbetrieb. Die Schaltkreisanordnung 10 ist ein Mikrocontroller mit einer CPU, Registern 11, ... und weiteren Komponenten und ist über Zuleitungsanschlüsse (Schaltungs-Versorgungs-Anschlüsse) 13 an zwei Versorgungskontakte C1, C5 angekoppelt. C1, C5 sind die beiden Versorgungskontakte eines sechs- oder achtflächigen Kontaktfelds gemäß ISO/IEC 7816-2.

Die Zerstörungseinrichtung 20 hat eine Zerstörungsleiterbahn 21 mit einem Sicherungsabschnitt 22 und ist über Zuleitungsanschlüsse (Zerstörungs-Versorgungs-Anschlüsse) 23 über eine Diode 24 an die zwei Versorgungskontakte C1, C5 angekoppelt. Der Sicherungsabschnitt 22 ist als Verdünnung der Zerstörungsleiterbahn 21 ausgebildet und ist benachbart zu einem Register 11 der CPU der Schaltkreisanordnung 10 angeordnet.

Zum normalen Betrieb (in Fig. 1 nicht gezeigt) der Schaltkreisanordnung 10 werden die Versorgungskontakte C1, C5 in normaler Polung, mit C1 als Versorgungs-Kontakt und C5 als Masse-Kontakt, mit einer normalen Versorgungsspannung beaufschlagt, z.B. je nach Schaltungstyp 5V, 3V oder 1,8V, entsprechend den Klassen A, B, C für die Versorgungsspannung gemäß ISO/IEC 7816-3. Hierdurch wird die Schaltkreisanordnung 10 mit der erforderlichen Betriebsspannung versorgt. In der Zerstörungsleiterbahn 21 fließt kein Strom, da die Diode 24 in Sperrrichtung beschaltet ist.

Zum Zerstörungsbetrieb (gezeigt in Fig.1) werden die Versorgungskontakte C1, C5 in umgekehrter oder vertauschter Polung, mit C5 als Versorgungs-Kontakt und C1 als Masse-Kontakt, mit einer Zerstörungsspannung beaufschlagt. Hierbei ist die Diode 24 in Durchlassrichtung beschaltet. Folglich fließt in der Zerstörungsleiterbahn 21 ein Strom. Die Zerstörungsspannung ist ausreichend hoch bemessen, dass der Strom ausreicht, um den Sicherungsabschnitt 22 zum Schmelzen zu bringen. Die beim Schmelzen entstehende Wärme wird in die Umgebung abgestrahlt und zerstört das Register 11 thermisch. Die Zerstörungsspannung ist betragsmäßig deutlich höher als die Versorgungsspannung und beträgt z.B.10 V, um ein versehentliches Aktivieren des Zerstörungsbetriebs zu verhindern, z.B. in dem Fall, dass im Normalbetrieb mit der normalen Versorgungsspannung (z.B. 5, 3, 1,8 V) versehentlich die Polung der Kontakte C1, C5 vertauscht wird.

Fig. 2 zeigt schematisch die Beschaltung der Zerstörungseinrichtung 20 aus Fig.1 im Zerstörungsbetrieb (oben) bzw. beim normalen Betrieb (unten) der Schaltungsanordnung 10 (in Fig. 2 weggelassen).

Fig. 3 zeigt schematisch ein Schaltbild einer Schaltkreisanordnung 10 und einer benachbart dazu angeordneten Zerstörungseinrichtung 20, gemäß einer weiteren Ausführungsform der Erfindung. Im Unterschied zur Ausführungsform aus Fig. 1 hat die Zerstörungseinrichtung 20 nicht nur eine einzelne Zerstörungsleiterbahn 21, sondern eine Mehrzahl von parallel geschalteten Zerstörungsleiterbahnen 21. Jede der Zerstörungsleiterbahnen 21 ist über die Diode 24 oder alternativ über eine eigene Diode (nicht gezeigt) von der Schaltkreisanordnung 10 elektrisch entkoppelt. Jede Zerstörungsleiterbahn 21 hat einen Sicherungsabschnitt 22, der benachbart zu einem sensiblen Element der Schaltkreisanordnung 10 angeordnet ist.

In der Darstellung als Schaltbild in Fig. 1 und Fig. 3 ist die Schaltkreisanordnung 10 räumlich getrennt von der Zerstörungseinrichtung 20 dargestellt. Tatsächlich ist die Zerstörungseinrichtung 20 derart benachbart zur Schaltkreisanordnung 10 angeordnet, dass die Zerstörungseinrichtung 20 in das Schaltungslayout der Schaltkreisanordnung 10 integriert ist und bei Bedarf räumlich (aber nicht elektrisch-galvanisch und nicht logisch) mit ihr verzahnt ist, so dass jeder Sicherungsabschnitt 22 räumlich benachbart zu einem gewünschten Element der Schaltkreisanordnung 10 angeordnet ist.

## Patentansprüche

1. Datenträger mit einer elektrischen Schaltkreisanordnung (10),
sowie mit einer benachbart zur Schaltkreisanordnung (10) angeordneten elektrischen Zerstörungseinrichtung (20), die zum Erzeugen von Wärme zur thermischen Zerstörung der Schaltkreisanordnung (10) in Reaktion auf einen die Zerstörungseinrichtung (20) durchfließenden Stromfluss eingerichtet ist und dazu eingerichtet ist, die Schaltkreisanordnung (10) zumindest teilweise funktionsunfähig zu machen,
**dadurch gekennzeichnet, dass**
die Zerstörungseinrichtung (20) unter Verwendung einer stromgleichrichtenden Einrichtung (24) von der Schaltkreisanordnung (10) entkoppelt ist.

2. Datenträger nach Anspruch 1, wobei die Zerstörungseinrichtung (20) mindestens eine Zerstörungsleiterbahn (21) mit zumindest einem durch Stromfluss mit ausreichender Stromstärke in der Zerstörungsleiterbahn (21) erhitzbaren Sicherungsabschnitt (22) aufweist.

3. Datenträger nach Anspruch 2, wobei der Sicherungsabschnitt (22) eng benachbart zu einem vorbestimmten Schaltkreisteil (11) der Schaltkreisanordnung (10) angeordnet ist, der für die Funktionsfähigkeit der Schaltkreisanordnung (10) wesentlich ist oder/und für den eine Zerstörung durch die Zerstörungseinrichtung (20) gewünscht ist.

4. Datenträger nach Anspruch 3, wobei als vorbestimmter Schaltkreisteil (11) mindestens eine der folgenden Funktionseinheiten vorgesehen ist: ein oder mehrere Register einer CPU, ein Verstärker eines Bussystems, ein oder mehrere Teile einer Glue-Logik.

5. Datenträger nach einem der Ansprüche 1 bis 4, wobei die Zerstörungseinrichtung (20) so gestaltet ist, dass, bei einem Normalbetrieb des Datenträgers in einem Lesegerät für Datenträger, kein funktionsunfähig Machen der Schaltkreisanordnung (10) durch die Zerstörungseinrichtung (20) erfolgt.

6. Datenträger nach einem Ansprüche 1 bis 5, wobei ein Grenz-Stromfluss in der Zerstörungseinrichtung (20), ab dessen Erreichen oder Überschreiten die erzeugte Wärme ausreicht, um die Schaltkreisanordnung funktionsunfähig zu machen, höher ist, als ein beim Normalbetrieb des Datenträgers höchstens erzielbarer Maximal-Stromfluss.

7. Datenträger nach einem Ansprüche 1 bis 6, wobei die Schaltkreisanordnung (10) zwei Schaltungs-Versorgungs-Anschlüsse (13) aufweist, über welche die Schaltkreisanordnung (10) mit einer Versorgungsspannung beaufschlagbar ist, und wobei die Zerstörungseinrichtung (20) zwei von den Schaltungs-Versorgungs-Anschlüssen (13) unter Verwendung der stromgleichrichtenden Einrichtung (24) entkoppelte Zerstörungs-Versorgungs-Anschlüsse (23) aufweist.

8. Datenträger nach einem Anspruch 7, der weiter ein Kontaktfeld mit einer Mehrzahl von Kontakten (C1-C6; C1-C8) zur galvanischen Kontaktierung der Schaltkreisanordnung (10) aufweist, wobei zwei Versorgungs-Kontakte (C1, C5) der Kontakte (C1-C6; C1-C8) mit den Schaltungs-Versorgungs-Anschlüssen (13) und mit den Zerstörungs-Versorgungs-Anschlüssen (23) elektrisch koppelbar sind.

9. Datenträger nach einem der Ansprüche 1 bis 8, wobei die Zerstörungseinrichtung (20) zur Schaltkreisanordnung (10) parallel geschaltet ist.

10. Verfahren zum funktionsunfähig Machen eines Datenträgers mit einer elektrischen Schaltkreisanordnung (10),
sowie mit einer benachbart zur Schaltkreisanordnung (10) angeordneten elektrischen Zerstörungseinrichtung (20), die zum Erzeugen von Wärme in Reaktion auf einen die Zerstörungseinrichtung (20) durchfließenden Stromfluss eingerichtet ist und dazu eingerichtet ist, die Schaltkreisanordnung (10) zumindest teilweise funktionsunfähig zu machen,
**dadurch gekennzeichnet, dass**
die Zerstörungseinrichtung (20) unter Verwendung einer stromgleichrichtenden Einrichtung (24) von der Schaltkreisanordnung (10) entkoppelt ist, und dass eine Beabstandung zwischen der Zerstörungseinrichtung (20) und der Schaltkreisanordnung (10) derart geeignet gewählt ist, dass die erzeugte Wärme ausreicht, um die Schaltkreisanordnung (10) thermisch zu beschädigen oder zu zerstören und dadurch funktionsunfähig zu machen,
wobei die Schaltkreisanordnung (10) zwei Schaltungs-Versorgungs-Anschlüsse (13) aufweist, über welche die Schaltkreisanordnung (10) mit einer Versorgungsspannung beaufschlagbar ist, und wobei die Zerstörungseinrichtung (20) zwei von den Schaltungs-Versorgungs-Anschlüssen (13) unter Verwendung der stromgleichrichtenden Einrichtung (24) entkoppelte Zerstörungs-Versorgungs-Anschlüsse (23) aufweist,
wobei eine elektrische Zerstörungsspannung an die Zerstörungs-Versorgungs-Anschlüsse (23) angelegt wird, die ausreichend hoch ist, damit ausreichend Wärme erzeugt wird, um die Schaltkreisanordnung thermisch zu zerstören.

11. Verfahren nach Anspruch 10, wobei, während die elektrische Zerstörungsspannung an die Zerstörungs-Versorgungs-Anschlüsse (23) angelegt ist, ein elektrischer Widerstand der Zerstörungseinrichtung im Verlauf der Zeit gemessen wird, und wobei das funktionsunfähig Machen als vollendet bewertet wird, sobald der elektrische Widerstand einen vorbestimmten Grenz-Widerstand erreicht oder überschritten hat.

12. Verfahren nach Anspruch 10 oder 11, das in einem Terminal für Datenträger in einem gesicherten Bereich einer Anlage zur Produktion von Datenträgern durchgeführt wird.

13. Verfahren nach Anspruch 10 oder 11, das in einem Terminal für Datenträger in einem öffentlich zugänglichen Bereich durchgeführt wird, insbesondere in einem Zahlungsverkehrterminal oder einem Geldausgabeautomaten.

## Claims

1. A data carrier having an electrical circuit arrangement (10),
and having an electrical destruction device (20) arranged adjacent to the circuit arrangement (10), said device being adapted for generating heat for thermally destroying the circuit arrangement (10) in reaction to a current flow flowing through the destruction device (20) and being adapted to make the circuit arrangement (10) at least partly inoperable,
**characterized in that**
the destruction device (20) is decoupled from the circuit arrangement (10) with the use of a current-rectifying device (24).

2. The data carrier according to claim 1, wherein the destruction device (20) has at least one destructible conducting path (21) with at least one fuse portion (22) heatable by current flow with sufficient current strength in the destructible conducting path (21).

3. The data carrier according to claim 2, wherein the fuse portion (22) is arranged closely adjacent to a predetermined circuit part (11) of the circuit arrangement (10) that is essential for the operability of the circuit arrangement (10) or/and for which a destruction through the destruction device (20) is desired.

4. The data carrier according to claim 3, wherein as a predetermined circuit part (11) there is provided at least one of the following functional units: one or several registers of a CPU, an amplifier of a bus system, one or several parts of a glue logic.

5. The data carrier according to any of claims 1 to 4, wherein the destruction device (20) is so designed that there is no making inoperable of the circuit arrangement (10) through the destruction device (20) upon a normal operation of the data carrier in a reading device for data carriers.

6. The data carrier according to any of claims 1 to 5, wherein a limiting current flow in the destruction device (20) as of the reaching or exceeding of which the generated heat suffices to make the circuit arrangement inoperable is higher than a maximum current flow at most attainable upon normal operation of the data carrier.

7. The data carrier according to any of claims 1 to 6, wherein the circuit arrangement (10) has two circuit supply connections (13) via which the circuit arrangement (10) is subjectable to a supply voltage, and wherein the destruction device (20) has two destruction supply connections (23) decoupled from the circuit supply connections (13) with the use of the current-rectifying device (24).

8. The data carrier according to claim 7, which further has a contact pad with a plurality of contacts (C1-C6; C1-C8) for galvanic contacting of the circuit arrangement (10), wherein two supply contacts (C1, C5) of the contacts (C1-C6; C1-C8) are electrically coupleable to the circuit supply connections (13) and to the destruction supply connections (23).

9. The data carrier according to any of claims 1 to 8, wherein the destruction device (20) is parallel-connected to the circuit arrangement (10).

10. A method for making inoperable a data carrier having an electrical circuit arrangement (10),
and having an electrical destruction device (20) arranged adjacent to the circuit arrangement (10), said device being adapted for generating heat in reaction to a current flow flowing through the destruction device (20) and being adapted to make the circuit arrangement (10) at least partly inoperable,
**characterized in that**
the destruction device (20) is decoupled from the circuit arrangement (10) with the use of a current-rectifying device (24),
and that a spacing between the destruction device (20) and the circuit arrangement (10) is suitably chosen such that the generated heat suffices to thermally damage or destroy the circuit arrangement (10) and thereby make it inoperable,
whereby the circuit arrangement (10) has two circuit supply connections (13) via which the circuit arrangement (10) is subjectable to a supply voltage, and whereby the destruction device (20) has two destruction supply connections (23) decoupled from the circuit supply connections (13) with the use of the current-rectifying device (24), whereby there is applied to the destruction supply connections (23) an electrical destruction voltage which is sufficiently high in order for sufficient heat to be generated to thermally destroy the circuit arrangement

11. The method according to claim 10, wherein, while the electrical destruction voltage is applied to the destruction supply connections (23), an electrical resistance of the destruction device is measured in the course of time, and wherein the making inoperable is rated as complete as soon as the electrical resistance has reached or exceeded a predetermined limiting resistance.

12. The method according to claim 10 or 11, which is carried out in a terminal for data carriers in a secure region of a plant for producing data carriers.

13. The method according to claim 10 or 11, which is carried out in a terminal for data carriers in a publicly accessible region, in particular in a payment transaction terminal or a money dispensing machine.

## Revendications

1. Support de données comprenant un agencement de circuit électrique (10) ainsi qu'un dispositif électrique de destruction (20) agencé de manière avoisinant l'agencement de circuit (10), qui est configuré pour générer de la chaleur destinée à la destruction thermique de l'agencement de circuit (10) en réaction à un flux de courant traversant le dispositif de destruction (20) et est configuré pour anéantir au moins partiellement l'aptitude à fonctionner de l'agencement de circuit (10), **caractérisé en ce que**
le dispositif de destruction (20) est découplé de l'agencement de circuit (10) par utilisation d'un dispositif redressant le courant (24).

2. Support de données selon la revendication 1, le dispositif de destruction (20) comportant au moins une piste conductrice de destruction (21) comportant au moins un tronçon de sécurisation (22) échauffable par flux de courant avec une intensité de courant suffisante dans la piste conductrice de destruction (21).

3. Support de données selon la revendication 2, le tronçon de sécurisation (22) étant agencé de manière avoisinant étroitement une portion de circuit (11) prédéterminée de l'agencement de circuit (10) qui est essentielle pour l'aptitude à fonctionner de l'agencement de circuit (10) et/ou pour laquelle une destruction par le dispositif de destruction (20) est souhaitée.

4. Support de données selon la revendication 3, au moins une des unités fonctionnelles suivantes étant prévue en tant que portion de circuit (11) prédéterminée: un ou plusieurs registres d'une CPU, un amplificateur d'un système bus, une ou plusieurs parties d'une logique Glue.

5. Support de données selon une des revendications de 1 à 4, le dispositif de destruction (20) étant conçu de telle manière que, lors d'un fonctionnement normal du support de données dans un appareil de lecture pour supports de données, il ne se produit pas d'anéantissement de l'aptitude à fonctionner de l'agencement de circuit (10) par le dispositif de destruction (20).

6. Support de données selon une des revendications de 1 à 5, un flux de courant limite à partir de l'atteinte ou du dépassement duquel la chaleur générée suffit pour anéantir l'aptitude à fonctionner de l'agencement de circuit étant, dans le dispositif de destruction (20), plus élevé qu'un flux de courant maximal au plus atteignable lors du fonctionnement normal du support de données.

7. Support de données selon une des revendications de 1 à 6, l'agencement de circuit (10) comportant deux bornes d'alimentation de circuit (13) par l'intermédiaire desquelles l'agencement de circuit (10) peut être alimenté avec une tension d'alimentation, et le dispositif de destruction (20) comportant deux bornes d'alimentation de destruction (23) découplées des bornes d'alimentation de circuit (13) par utilisation du dispositif redressant le courant (24).

8. Support de données selon la revendication 7, qui comporte en outre un champ de contact comprenant une pluralité de contacts (C1-C6; C1-C8) pour la mise en contact de l'agencement de circuit (10) par galvanisation, deux contacts d'alimentation (C1, C5) des contacts (C1-C6; C1-C8) comprenant les bornes d'alimentation de circuit (13) et les bornes d'alimentation de destruction (23) pouvant être couplés électriquement.

9. Support de données selon une des revendications de 1 à 8, le dispositif de destruction (20) étant branché en parallèle à l'agencement de circuit (10).

10. Procédé d'anéantissement de l'aptitude à fonctionner d'un support de données comprenant un agencement de circuit électrique (10) ainsi qu'un dispositif électrique de destruction (20) agencé de manière avoisinant l'agencement de circuit (10), qui est configuré pour générer de la chaleur en réaction à un flux de courant traversant le dispositif de destruction (20) et est configuré pour anéantir au moins partiellement l'aptitude à fonctionner de l'agencement de circuit (10),
**caractérisé en ce que**
le dispositif de destruction (20) est découplé de l'agencement de circuit (10) par utilisation d'un dispositif redressant le courant (24), et **en ce qu'**un espacement entre le dispositif de destruction (20) et l'agencement de circuit (10) est sélectionné de manière appropriée de telle sorte que la chaleur générée suffit pour endommager ou détruire thermiquement l'agencement de circuit (10) et en anéantir ainsi l'aptitude à fonctionner, l'agencement de circuit (10) comportant deux bornes d'alimentation de circuit (13) par l'intermédiaire desquelles l'agencement de circuit (10) peut être alimenté avec une tension d'alimentation, et le dispositif de destruction (20) comportant deux bornes d'alimentation de destruction (23) découplées des bornes d'alimentation de circuit (13) par utilisation du dispositif redressant le courant (24),
une tension électrique de destruction étant appliquée aux bornes d'alimentation de destruction (23), qui est suffisamment élevée pour que suffisamment de chaleur soit générée pour détruire thermiquement l'agencement de circuit.

11. Procédé selon la revendication 10, une résistance électrique du dispositif de destruction étant, pendant que la tension électrique de destruction est appliquée aux bornes d'alimentation de destruction (23), mesurée en fonction du temps, et l'anéantissement de l'aptitude à fonctionner étant estimée accomplie dès que la résistance électrique a atteint ou dépassé une résistance limite prédéterminée.

12. Procédé selon la revendication 10 ou 11, qui est exécuté dans un terminal pour supports de données dans une zone sécurisée d'une installation de production de supports de données.

13. Procédé selon la revendication 10 ou 11, qui est exécuté dans un terminal pour supports de données dans une zone publiquement accessible, notamment dans un terminal de transactions financières ou un distributeur automatique de billets.
